# EUROPEAN PATENT APPLICATION

(11) **EP 4 579 257 A1**
(43) Date of publication of application: **02.07.2025**
(21) Application number: 24843344.3
(22) Date of filing: 25.06.2024
(51) Int. Cl.: G01R 31/371, G01R 31/396, G07C 5/00, H04L 12/40

(54) **FDC (FAULT DETECTION COUNTER) INFORMATION ABOUT DTC (DIAGNOSTIC TROUBLE CODE) TRANSCEIVING METHOD AND BATTERY SYSTEM USING SAME METHOD**

(30) Priority: 17.07.2023 KR 20230092579
(71) Applicant: LG Energy Solution, Ltd., Seoul 07335 (KR)
(72) Inventor: CHOI, Hodeuk, Daejeon 34122 (KR); JEON, Younghwan, Daejeon 34122 (KR); HONG, Junhyeon, Daejeon 34122 (KR)
(74) Representative: Plasseraud IP
(86) International application number: PCT/KR2024/008749
(87) International publication number: WO 2025/018624

(57) **Abstract**

The present disclosure relates to a method for transmitting and receiving fault detection counter (FDC) information for a diagnostic trouble code (DTC) and a battery system using the same. According to an exemplary embodiment of the disclosure, a method for transmitting and receiving FDC information for a DTC by a battery system includes: receiving a request message; and transmitting a response message corresponding to the request message, wherein a data information area of the request message includes a data delimiter and diagnostic information data, the data delimiter is a first type for requesting a read of an FDC corresponding to each of at least one piece of DTC information included in the request message, or a second type for requesting a read of a plurality of FDCs according to a bitmap, and the bitmap is a list in which a plurality of pieces of DTC diagnostic information match a plurality of bits constituting the diagnostic information data.

## Description

### [Technical Field]

CROSS-REFERENCE TO RELATED APPLICATION

This application claims priority to and the benefit of Korean Patent Application No. 10-2023-0092579 filed in the Korean Intellectual Property Office on July 17, 2023, the entire contents of which are incorporated herein by reference.

The present disclosure relates to a method for transmitting and receiving fault detection counter (FDC) information for a diagnostic trouble code (DTC) and a battery system using the same.

### [Background Art]

According to the ISO-14229 standard protocol definition, a response to a request regarding the diagnostic trouble code (DTC) status may express the fault status for a diagnosis through a fault detection counter (FDC).

Meanwhile, diagnostic information for checking thermal events or isolation events regarding batteries have recently been required to read and check multiple states simultaneously at a specific time point.

### [Disclosure]

### [Technical Problem]

The present disclosure attempts to provide a method for transmitting and receiving fault detection counter (FDC) information for a diagnostic trouble code (DTC), capable of expressing a plurality of DTCs and FDCs corresponding thereto in one message, and a battery system using the same.

### [Technical Solution]

An exemplary embodiment of the present disclosure provides a method for transmitting and receiving fault detection counter (FDC) information for a diagnostic trouble code (DTC) by a battery system, the method including: receiving a request message; and transmitting a response message corresponding to the request message, wherein a data information area of the request message includes a data delimiter and diagnostic information data, wherein the data delimiter is a first type for requesting a read of an FDC corresponding to each of at least one piece of DTC information included in the request message, or a second type for requesting a read of a plurality of FDCs according to a bitmap, and wherein the bitmap is a list in which a plurality of pieces of DTC diagnostic information match a plurality of bits constituting the diagnostic information data.

If the data delimiter is the second type, the diagnostic information data may include binary data in which a binary value corresponds to each of the plurality of bits, and bits having a first value among the binary data may match a plurality of first DTCs based on the bitmap.

A data information area of the response message may include a plurality of FDCs corresponding to the plurality of first DTCs.

If the plurality of first DTCs include a DTC matching a first bit and a DTC matching a second bit greater than the first bit based on the bitmap, a data information area of the response message may include a data information area in which an FDC corresponding to the DTC matching the first bit and an FDC corresponding to the DTC matching the second bit are arranged sequentially.

If the response message is of the first type, the diagnostic information data may include first DTC information and second DTC information.

A data information area of the response message may be configured by sequentially arranging the first DTC information, an FDC corresponding to the first DTC information, the second DTC information, and an FDC corresponding to the second DTC information.

Another exemplary embodiment of the present disclosure provides a battery system for transmitting and receiving fault detection counter (FDC) information for a diagnostic trouble code (DTC) to and from a vehicle, the battery system including: a battery pack including a plurality of battery cells; and a battery management system (BMS) configured to manage the battery pack, wherein the BMS receives a request message from the vehicle, and transmits a response message corresponding to the request message to the vehicle, a data information area of the request message includes a data delimiter and diagnostic information data, the data delimiter is a first type for requesting a read of an FDC corresponding to each of at least one piece of DTC information included in the request message, or a second type for requesting a read of a plurality of FDCs according to a bitmap, and the bitmap is a list in which a plurality of pieces of DTC diagnostic information match a plurality of bits constituting the diagnostic information data.

If the data delimiter is the second type, the diagnostic information data may include binary data in which a binary value corresponds to each of the plurality of bits, and a plurality of first bits matching a plurality of pieces of DTC diagnostic information to be requested to be read based on the bitmap, among the plurality of bits represented by the binary data, may have a first value, and a remainder plurality of bits excluding the plurality of first bits may have a second value.

A data information area of the response message may include a plurality of FDCs corresponding to the plurality of first DTCs.

If the plurality of first DTCs include a DTC matching a first bit and a DTC matching a second bit greater than the first bit based on the bitmap, the BMS may configure a data information area of the response message by sequentially arranging an FDC corresponding to the DTC matching the first bit and an FDC corresponding to the DTC matching the second bit.

If the response message is of the first type, the diagnostic information data may include first DTC information and second DTC information.

The BMS may configure a data information area of the response message by sequentially arranging the first DTC information, an FDC corresponding to the first DTC information, the second DTC information, and an FDC corresponding to the second DTC information.

### [Advantageous Effects]

According to the present disclosure, a request message requests DTC information using a bitmap for a plurality of pieces of DTC information, and a response message thereto includes all of a plurality of pieces of diagnostic information according to the bitmap, thereby making it possible to utilize a small amount of data in diagnosing FDC information corresponding to the plurality of DTCs.

According to the present disclosure, in a case where a CAN FD channel is utilized, data is transmitted as many as DTCs, thereby making it possible to flexibly use a data buffer.

If a response message includes one FDC corresponding to each DTC, it may be difficult to accurately diagnose a vehicle due to the time interval between the times at which the packets for the respective response messages are received. According to the present disclosure, since a response message includes a plurality of pieces of FDC information, a plurality of pieces of data indicating the status of the vehicle at a specific time point can be checked at once for diagnosis.

### [Description of the Drawings]

FIG. 1 is a diagram illustrating a vehicle and a battery system to which an exemplary embodiment is applied.
FIG. 2 is a diagram illustrating a partial configuration of a vehicle according to an exemplary embodiment.
FIG. 3 is a diagram illustrating a partial configuration of a battery system according to an exemplary embodiment.
FIG. 4 is a diagram illustrating a structure of a request message using a bitmap according to an exemplary embodiment.
FIG. 5 is a diagram illustrating a structure of a data information area of FIG. 4.
FIG. 6 is an example of a bitmap indicating a plurality of bits corresponding to a plurality of DTCs according to an exemplary embodiment.
FIG. 7 is a diagram illustrating a structure of a response message using a bitmap according to an exemplary embodiment.
FIG. 8 is a diagram illustrating a structure of a request message that does not use a bitmap according to an exemplary embodiment.
FIG. 9 is a diagram illustrating a structure of a data information area of FIG. 8.
FIG. 10 is a diagram illustrating a structure of a response message that does not use a bitmap according to an exemplary embodiment.

### [Mode for Invention]

Hereinafter, exemplary embodiments will be described in detail with reference to the accompanying drawings, and the same or similar components will be given the same or similar reference numerals and redundant descriptions thereof will be omitted. The suffixes "module" and/or "unit" for components used in the following description are assigned or mixed in consideration of easiness in writing the specification and do not have distinctive meanings or roles by themselves. In addition, in describing exemplary embodiments herein, detailed descriptions of relevant known technologies will be omitted if they obscure the gist of the exemplary embodiments disclosed herein. Further, the accompanying drawings are provided only to help easily understand exemplary embodiments disclosed herein, and it should be understood that the technical idea disclosed herein is not limited by the accompanying drawings, and covers all modifications, equivalents, and substitutions falling within the spirit and the technical scope of the present disclosure.

Terms including ordinal numbers such as "first" and "second" may be used to describe various components, but these components are not limited by these terms. These terms are used only for the purpose of distinguishing one component from another component.

It is to be understood that when one component is referred to as being "connected to" or "coupled to" another component, one component may be connected or coupled directly to another component or be connected or coupled to another component with an intervening component therebetween. On the other hand, it is to be understood that when one component is referred to as being "directly connected to" or "directly coupled to" another component, one component may be connected to another component with no intervening component therebetween.

It should be understood that terms "include", "have", and the like used herein specify the presence of features, numbers, steps, operations, components, parts, or combinations thereof stated in the specification, but do not preclude the possibility of the presence or addition of one or more other features, numbers, steps, operations, components, parts, or combinations thereof.

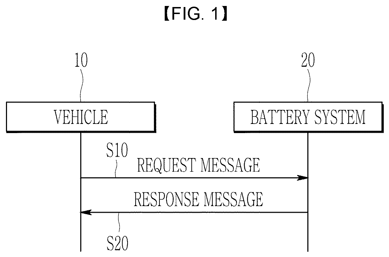

FIG. 1 is a diagram illustrating a vehicle and a battery system to which an exemplary embodiment is applied.

A vehicle 10 may transmit a request message to a battery system 20 to obtain diagnostic trouble code (DTC)-related information (hereinafter, DTC information) (S10).

The battery system 20 may receive the request message, generate a response message to the request message, and transmit the response message to the vehicle 10 (S20).

In FIG. 1, a vehicle and a battery system are illustrated as examples of a diagnostic device and a diagnostic target that transmit and receive messages, but the disclosure is not limited thereto. An exemplary embodiment may be applied to a device capable of performing a diagnosis on a battery and storing information about a result of performing the diagnosis, such as a battery system.

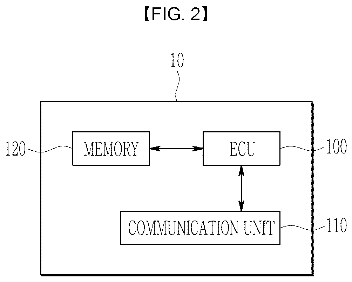

FIG. 2 is a diagram illustrating a partial configuration of a vehicle according to an exemplary embodiment.

As illustrated in FIG. 2, the vehicle 10 may include an electronic control unit (ECU) 100, a communication unit 110, and a memory 120.

The ECU 100 may generate a request message, collects necessary data from a received response message, and performs a series of operations for controlling the operations of the vehicle 10. The request message may be a message requesting information on a DTC belonging to the specific DTC status and a fault detection counter FDC corresponding to the DTC.

The communication unit 110 may transmit a request message to the outside and receive a response message to the request message. For example, the communication unit 110 may transmit a request message to the battery system 20 and receive a response message from the battery system 20.

The memory 120 may store data collected from the response message by the ECU 100. The memory 120 may store data necessary for the ECU 100 to control an operation of generating a request message, an operation of the vehicle 10, etc.

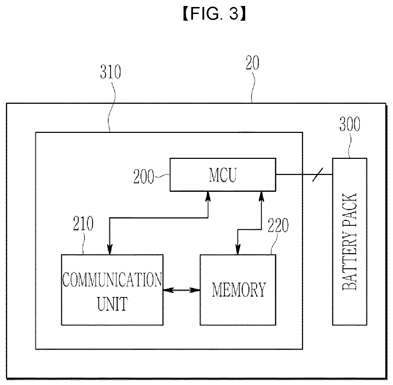

FIG. 3 is a diagram illustrating a partial configuration of a battery system according to an exemplary embodiment.

As illustrated in FIG. 3, the battery system 20 may include a battery pack 300 including a plurality of battery cells, and a battery management system (BMS) 310 that manages a battery pack by performing operations of charging/discharging, monitoring, and protecting the battery pack 300. The BMS 310 may include a main control unit (MCU) 200, a communication unit 210, and a memory 220.

The MCU 200 performs a diagnosis according to the received request message, generates a response message based on a diagnosis result, and performs a series of operations for controlling the operations of the BMS 20.

The communication unit 210 receives a request message and transmits a response message to the outside. For example, the communication unit 210 may receive a request message from the vehicle 10, and transmit a response message to the vehicle 10.

The memory 220 stores a diagnosis content and a result according to the performed diagnosis. The MCU 200 may detect and read necessary information from the memory 220 to generate a response message. The memory 220 may store data necessary for the MCU 200 to control the BMS 20.

FIGS. 2 and 3 illustrate only configurations necessary to describe an exemplary embodiment. Configurations not illustrated in FIGS. 2 and 3 may be included in the vehicle and the battery system.

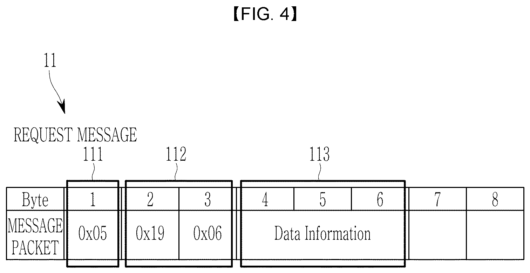

FIG. 4 is a diagram illustrating a structure of a request message using a bitmap according to an exemplary embodiment.

As illustrated in FIG. 4, a request message 11 may include a packet size information area 111, a packet identification information area 112, and a data information area 113. The number illustrated in FIG. 4 may be hexadecimal and expressed as 1 byte, and the size of data illustrated as one cell in FIG. 4 may be 1 byte.

The packet size information area 111 may include a data length code (DLC). The DLC may define a size obtained by summing an amount of data in the packet identification information area 112 and an amount of data in the data information area 113 of the request message. For example, as illustrated in FIG. 4, "0x05" recorded in byte number 1, which is a packet size information area 111, may indicate that the size obtained by summing the amount of data in the packet identification information area 112 and the amount of data in the data information area 113 is 5 bytes.

The packet identification information area 112 may correspond to an area of 2 bytes or more. A service identifier (Service ID) may be recorded in a first byte of the packet identification information area 112, and a data identifier (Data ID) may be recorded in a second byte of the packet identification information area 112.

As illustrated in FIG. 4, "0x19" recorded in byte number 2 of the packet identification information area 112 may be an example of a service identifier requesting a service for reading DTC information (DTC Read Service ID). That is, if the service identifier is "0x19", the message may be a message requesting a service for the ECU 100 to read DTC information stored in the BMS 310. Upon this request, the BMS 310 may read the stored DTC information and transmit the read DTC information to the ECU 100. At this time, the BMS 310 needs information to specify which of the plurality of pieces of the stored DTC information to read.

As illustrated in FIG. 4, "0x06" recorded in byte number 3 of the packet identification information area 112 may be an example of a data identifier requesting FDC data corresponding to a DTC (FDC Read Service ID). That is, if the data identifier is "0x06" in the request message, the request message may be a message in which the ECU 100 requests FDC data among the DTC information stored in the BMS 310. Upon this request, the BMS 310 may read an FDC for the stored DTC and transmit the read FDC to the ECU 100.

The data information area 113 may correspond to a plurality of bytes starting from byte number 4. Although it is illustrated in FIG. 4 that the data information area 113 is an area corresponding to three bytes, byte numbers 4, 5, and 6, this is for convenience of explanation, and exemplary embodiments are not limited thereto.

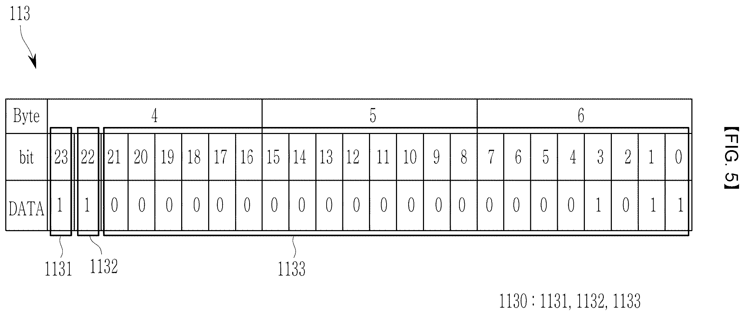

FIG. 5 is a diagram illustrating a structure of the data information area of FIG. 4.

Referring to FIG. 5, the data information area 113 corresponds to a plurality of bytes, and bits constituting each of the plurality of bytes may include a value for specifying a DTC requested to be read.

The number illustrated in FIG. 5 may be binary and expressed as 1 bit, and the size of data illustrated as one cell in FIG. 5 may be 1 bit.

As illustrated in FIG. 5, it will be assumed in the following description that the data information area 113 is a 3-byte area.

**The** data information area 113 may include request data 1130 capable of specifying a **DTC** requested to be read. **The** request data 1130 may be binary data sorted and arranged in bit descending order in the data information area 113. As illustrated in FIG. 5, 24-bit binary data "11000000 00000000 00001011" from data corresponding to bit number 23 to data corresponding to bit number 0 may be an example of the request data 1130.

Referring to FIG. 5, the request data 1130 may include a communication channel identifier 1131, a response type identifier 1132, and data information 1133.

The communication channel identifier 1131 may specify a communication channel for receiving a response message. The communication channel for receiving a response message may be one of a plurality of communication channels. The plurality of communication channels may include a first communication channel and a second communication channel.

The first communication channel may be a communication channel of which the maximum amount of data that can be transmitted is set to a predetermined first reference amount. The second communication channel may be a communication channel of which the maximum amount of data that can be transmitted is set to a predetermined second reference amount that is greater than the first reference amount.

Specifically, the first communication channel may be a channel of which the total amount of message packet data that can be transmitted at one time is set to be smaller than the total amount of message packet data that the second communication channel can transmit at one time. For example, the first communication channel may be a CAN communication channel, and the second communication channel may be a CAN FD channel.

A CAN FD channel is a communication standard developed to complement the shortcomings of the CAN channel, and is a communication channel of which the maximum amount of data that can be included is greater than that of the CAN channel. For example, if the maximum amount of data that can be included in a packet transmitted through the CAN channel is 8 bytes, the maximum amount of data that can be included in a packet transmitted through the CAN FD channel can be 64 bytes.

For example, as illustrated in FIG. 5, "1" recorded in bit number 23 representing the communication channel identifier 1131 may indicate that the communication channel for the request message 11 is the second communication channel.

The response type identifier 1132 may specify the requested data delimiter. The data delimiter may be one of a plurality of types. The plurality of types may include a first type and a second type.

The first type may be a type for requesting a read of an FDC corresponding to each of at least one piece of DTC information included in the request message without using a bitmap. The second type may be a type for requesting a read of an FDC corresponding to each of a plurality of DTCs represented by a plurality of bits indicated by a request message according to a bitmap. Here, the bitmap can be a list in which a plurality of pieces of DTC diagnostic information match a plurality of bits. DTC diagnostic information may include DTC information, a diagnosis name indicated by the DTC information, etc.

For example, as illustrated in FIG. 5, "1" recorded in bit number 22 representing the response type identifier 1132 may indicate that the data delimiter is the second type.

Although it is illustrated in FIG. 5 that each of the communication channel identifier 1131 and the response type identifier 1132 is a binary number corresponding to 1 bit, this is for convenience of explanation and the disclosure is not limited thereto. Each of the communication channel identifier 1131 and the response type identifier 1132 may be a hexadecimal number corresponding to 1 byte.

Hereinafter, the case where the data delimiter is the second type will be described with reference to FIGS. 5 to 7.

Referring to FIG. 5, when the data delimiter is the second type, the data information 1133 may include diagnostic information data included in a plurality of bits. The diagnostic information data may be binary data in which a binary value corresponds to each of the plurality of bits. The diagnostic information data may include a plurality of DTCs requested to be read.

Among the plurality of bits represented by the diagnostic information data, bits having a first value (e.g., "1") may match a plurality of pieces of DTC information to be requested to be read based on the bitmap. In addition, among the plurality of bits represented by the diagnostic information data, the remaining bits, excluding the bits matching the plurality of pieces of DTC information to be requested to be read, may have a second value (e.g., "0").

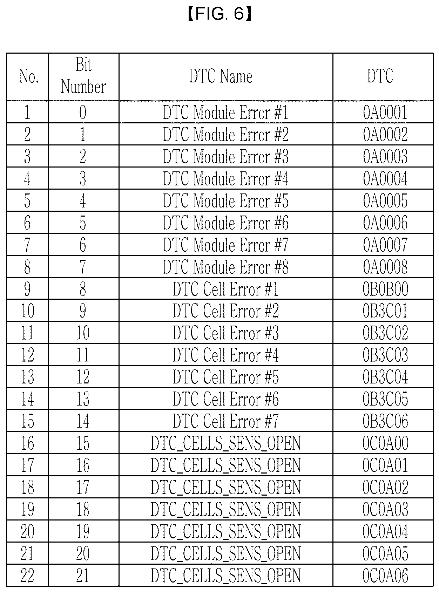

FIG. 6 is an example of a bitmap indicating a plurality of bits corresponding to a plurality of DTCs according to an exemplary embodiment.

The plurality of bits included in the bitmap may be sorted in ascending or descending order, and each of the bits may match to correspond to one of the plurality of DTCs.

Referring to FIG. 6, the bitmap may be a list in which a number of each of the plurality of bits represented by the diagnostic information data, a DTC, and a name of a diagnosis indicated by the DTC (DTC Name) match each other. The plurality of pieces of DTC diagnostic information indicated by the plurality of pieces of DTC information may correspond to the plurality of bits. As illustrated in FIG. 6, "OA0001" to "OA0008", "0B0B00", "0B3C01" to "0B3C06", and "0C0A00" to "0C0A06" may be examples of the plurality of DTCs.

Hereinafter, the example of the bitmap illustrated in FIG. 6 will be described.

Bit number 0 may match DTC "0A0001" representing diagnosis name "DTC Module Error #1", and bit number 1 may match DTC "0A0002" representing diagnosis name "DTC Module Error #2". Bit number 2 may match DTC "0A0003" representing diagnosis name "DTC Module Error #3", and bit number 3 may match DTC "0A0004" representing diagnosis name "DTC Module Error #4". Bit number 4 may match DTC "0A0005" representing diagnosis name "DTC Module Error #5", and bit number 5 may match DTC "0A0006" representing diagnosis name "DTC Module Error #6". Bit number 6 may match DTC "0A0007" representing diagnosis name "DTC Module Error #7", and bit number 7 may match DTC "0A0008" representing diagnosis name "DTC Module Error #8". Among the diagnosis names, a name including "DTC Module Error" may indicate a predetermined error that has occurred in each of a plurality of modules included in the battery pack 300.

Bit number 8 may match DTC "0B0B00" representing diagnosis name "DTC cell Error #1", and bit number 9 may match DTC "0B3C01" representing diagnosis name "DTC cell Error #2". Bit number 10 may match DTC "0B3C02" representing diagnosis name "DTC cell Error #3", and bit number 11 may match DTC "0B3C03" representing diagnosis name "DTC cell Error #4". Bit number 12 may match DTC "0B3C04" representing diagnosis name "DTC cell Error #5", bit number 13 may match DTC "0B3C05" representing diagnosis name "DTC cell Error #6", and bit number 14 may match DTC "0B3C06" representing diagnosis name "DTC cell Error #7". Among the diagnosis names, a name including "DTC cell Error" may indicate a predetermined error that has occurred in each of a plurality of battery cells included in the battery pack 300.

Bit number 15 may match DTC "0C0A00" representing diagnosis name "DTC_CELL_SENSE_OPEN", and bit number 16 may match DTC "0C0A01" representing diagnosis name "DTC_CELL_SENSE_OPEN". Bit number 17 may match DTC "0C0A02" representing diagnosis name "DTC_CELL_SENSE_OPEN", and bit number 18 may match DTC "0C0A03" representing diagnosis name "DTC_CELL_SENSE_OPEN". Bit number 19 may match DTC "0C0A04" representing diagnosis name "DTC_CELL_SENSE_OPEN", bit number 20 may match DTC "0C0A05" representing diagnosis name "DTC_CELL_SENSE_OPEN", and bit number 21 may match DTC "0C0A06" representing diagnosis name "DTC_CELL_SENSE_OPEN". Among the diagnosis names, a name including "DTC_CELL_SENSE_OPEN" may indicate a predetermined error that occurred in detecting cell information (e.g., cell voltage, cell temperature, cell current, etc.) for each of the plurality of battery cells included in the battery pack 300.

Each of the plurality of pieces of DTC diagnostic information indicated by the bitmap may indicate battery conditions, such as temperature, voltage, isolation error, communication error, and abnormal operation, for each of the plurality of battery cells included in the battery pack 300 and/or each of the plurality of battery modules included in the battery pack 300.

In this way, each bit constituting the diagnostic information data may correspond to a bit number according to the bitmap. In the data information 1133 illustrated in FIG. 5, bit number 21 to bit number 0 may correspond to bit number 21 to bit number 0 of the bitmap illustrated in FIG. 6. For example, in the data information 1133 illustrated in FIG. 5, data corresponding to DTC "0C0A06", which corresponds to bit number 21 of the bitmap illustrated in FIG. 6, may be recorded in bit number 21.

The value recorded in each of bit number 21 to bit number 0 of the diagnostic information data may be a first value (e.g., "1") or a second value (e.g., "0"). Among them, the DTC matching the bit in which first value is recorded according to the bitmap may indicate a DTC requested to be read by the request message 11.

Since data in bit numbers 0, 1, and 3 of the data information 1133 illustrated in FIG. 5 is "1" and data in the other bit numbers is "0", the request message 11 including the data information 1133 indicates the status in which DTCs "0A0001", "0A0002", and "0A0004" matching bit numbers 0, 1, and 3 of the bitmap illustrated in FIG. 6 are requested to be read.

In an exemplary embodiment, the request message 11 may request a plurality of pieces of DTC information in one data packet using a bitmap, and the length of the data information area 113 may be increased or decreased according to the number of a plurality of bits indicated by the bitmap.

In a method not using a bitmap, a request message may include at least one DTC in a packet, and may require at least 3-byte area for each of the at least one DTC. Accordingly, a request message for requesting information on five DTCs may require five packets with one DTC included in each packet, or may require an area of at least 3*5=15 bytes with 5 DTCs included in one packet.

In contrast, in an exemplary embodiment using a bitmap, the size of the data information area 113 can be reduced because a DTC can be specified by toggling bits pre-defined by the bitmap without including the DTC itself in the message.

In an exemplary embodiment, if the bitmap is a list indicating bits matching DTCs of the number is greater than 8*(m-1)-2 and smaller than or equal to 8*(m)-2, it is sufficient that the length of the data information area 113 is m bytes. However, this is for the case where each of the communication channel identifier 1131 and the response type identifier 1132 is a binary number corresponding to 1 bit. If the communication channel identifier 1131 and the response type identifier 1132 are k bits, and the bitmap is a list indicating bits matching DTCs of which the number is greater than 8*(m-1)-2*k and smaller than or equal to 8*(m)-2*k, the request message 11 may require an m-byte data information area 113. Here, m is a natural number greater than or equal to 2, and k is a natural number greater than or equal to 1.

For example, if the bitmap is a list of 35 pieces of DTC diagnostic information, each of which matches a bit, the request message 11 may require a 5-byte data information area 113.

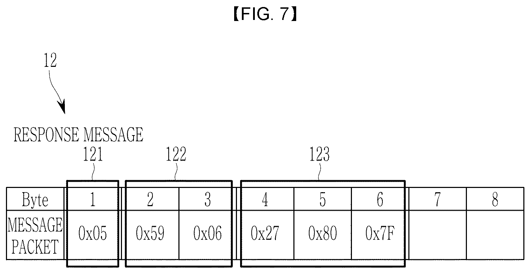

FIG. 7 is a diagram illustrating a structure of a response message using a bitmap according to an exemplary embodiment.

As illustrated in FIG. 7, a response message 12 may include a packet size information area 121, a packet identification information area 122, and a data information area 123. The number illustrated in FIG. 7 may be hexadecimal and expressed as 1 byte, and the size of data illustrated as one cell in FIG. 7 may be 1 byte.

The packet size information area 121 may include a data length code (DLC). The DLC may define a size obtained by summing an amount of data in the packet identification information area 122 and an amount of data in the data information area 123 of the response message. For example, as illustrated in FIG. 7, "0x05" recorded in byte number 1, which is a packet size information area 121, may indicate that the size obtained by summing the amount of data in the packet identification information area 122 and the amount of data in the data information area 123 is 5 bytes.

The packet identification information area 122 may correspond to an area of 2 bytes or more, and a service identifier (Service ID) may be recorded in a first byte of the packet identification information area 122, and a data identifier (Data ID) may be recorded in a second byte of the packet identification information area 122.

As illustrated in FIG. 7, "0x59" recorded in byte number 2 of the packet identification information area 122 may be an example of a service identifier indicating a response including DTC information (DTC Read Information Positive Response Service ID). That is, if the service identifier is "0x59", the message may be a message for the ECU 100 to respond with DTC information stored in the BMS 310.

As illustrated in FIG. 7, "0x06" recorded in byte number 3 of the packet identification information area 122 may be an example of a data identifier requesting FDC data corresponding to a DTC (FDC Read Service ID). That is, if the data identifier is "0x06" in the response message, the message may be a message indicating FDC data among the DTC information stored in the BMS 310.

When the number of pieces of DTC information requested to be read in request message 11 is n (n is a natural number greater than or equal to 2), the data information area 123 may correspond to an n-byte area.

For example, if a first bit and a second bit among the plurality of bits included in the data information area 113 of the request message 11 are "1" and the other bits are "0", the BMS 310 may configure the response message 12 in such a manner that, among the plurality of bytes included in the data information area 123, a first byte includes an FDC corresponding to a DTC matching the first bit, and a second byte includes an FDC corresponding to a DTC matching the second bit. Here, if the second bit is greater than the first bit, the BMS 310 may configure the data information area 123 by sequentially arranging the first byte and the second byte.

Referring to FIG. 7, the description will be made on the assumption that n is 3. The BMS 310 may configure the data information area 123 by sequentially arranging n FDCs for n DTCs.

Each of the n bytes included in the data information area 123 may include an FDC for the corresponding DTC information among the n pieces of DTC information requested to be read in the request message 11.

The MCU 200 may sort the n pieces of DTC information in ascending order of matching bit numbers based on the bitmap, and sequentially arrange FDCs for the respective pieces of DTC information in n bytes of the data information area 113 according to the sorting order.

It may be assumed that the n pieces of DTC information include a first DTC, a second DTC, and a third DTC, and the first DTC matches a first bit (e.g., bit number 0) based on the bitmap, the second DTC matches a second bit (e.g., bit number 1) greater than the first bit based on the bitmap, and the third DTC matches a third bit (e.g., bit number 3) greater than the second bit based on the bitmap.

In this case, the MCU 200 may configure the data information area 123 by sequentially arranging an FDC corresponding to the first DTC, an FDC corresponding to the second DTC, and an FDC corresponding to the third DTC according to the bit number order.

For example, it is assumed that the request message 11 has requested DTC information matching bit numbers 0, 1, and 3 based on the bitmap. The MCU 200 may sort the DTC information as "0A0001", "0A0002", and "0A0004" in ascending order of bit numbers 0, 1, and 3 matching the three pieces of information. The MCU 200 may record an FDC for the DTC "0A0001" in byte number 4 of the data information area 123, an FDC for the DTC "0A0002" in byte number 5, and an FDC for the DTC "0A0004" in byte number 6, according to the sorting order.

As illustrated in FIG. 7, "0x27" recorded in a fourth byte of the data information area 123 represents an example of an FDC for the DTC "0A0001", "0x80" recorded in a fifth byte of the data information area 123 represents an example of an FDC for the DTC "0A0002", and "0x7F" recorded in a sixth byte of the data information area 123 represents an example of an FDC for the DTC "0A0004".

In a method not using a bitmap, a response message may require a relatively large amount of data, including DTC information (DTCs) and corresponding status information (FDCs) in a data information area. In addition, in response to the requests to read the plurality of pieces of DTC information, each of the plurality of packets may include one of the plurality of DTCs and an FDC corresponding thereto, and in this case, a gap may occur between the times at which the plurality of packets representing responses to the requests to read the plurality of pieces of DTC information are generated.

In contrast, in an exemplary embodiment using a bitmap, a plurality of FDCs can be included in one packet according to the sorting order of bit numbers indicated by the bitmap without having to include the DTCs themselves in the response message 12, and the response message 12 can simultaneously transmit a plurality of pieces of status information in one packet, thereby reducing distortion due to gaps or delays.

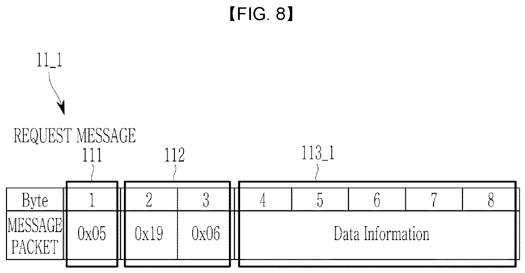

Hereinafter, the case where the data delimiter is the first type will be described with reference to FIGS. 8 to 10.

As described above, the first type may be a type for requesting a read of an FDC corresponding to each of the DTCs included in the request message without using a bitmap.

FIG. 8 is a diagram illustrating a structure of a request message that does not use a bitmap according to an exemplary embodiment.

As illustrated in FIG. 8, a request message 11_1 may include a packet size information area 111, a packet identification information area 112, and a data information area 113_1. The description of the packet size information area 111 and the packet identification information area 112 illustrated in FIG. 8 may be the same as the description of the packet size information area 111 and the packet identification information area 112 illustrated in FIG. 4. Hereinafter, the description of the packet size information area 111 and the packet identification information area 112 overlapping the above description may be omitted.

The number illustrated in FIG. 8 may be hexadecimal and expressed as 1 byte, and the size of data illustrated as one cell in the request message 11_1 may be 1 byte.

The data information area 113_1 may correspond to a plurality of bytes starting from byte number 4. Although it is illustrated in FIG. 8 that the data information area 113_1 is an area corresponding to five bytes, byte numbers 4 to 8, this is for convenience of explanation, and exemplary embodiments are not limited thereto.

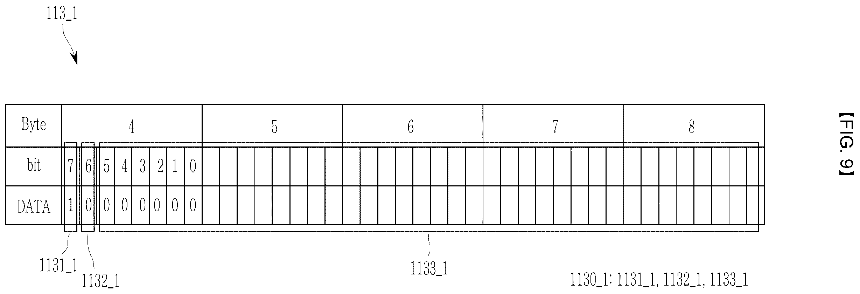

FIG. 9 is a diagram illustrating a structure of the data information area of FIG. 8.

Referring to FIG. 9, the data information area 113_1 corresponds to a plurality of bytes, and bits constituting each of the plurality of bytes may include a value for specifying a DTC requested to be read.

The number illustrated in FIG. 9 may be binary and expressed as 1 bit, and the size of data illustrated as one cell in FIG. 9 may be 1 bit.

As illustrated in FIG. 9, it will be assumed in the following description that the data information area 113_1 is a 5-byte area including byte numbers 4 to 8.

The data information area 113_1 may include request data 1130_1 capable of specifying a DTC requested to be read. The request data 1130_1 may be binary data sorted and arranged in a bit descending order in the data information area 113_1.

Referring to FIG. 9, the request data 1130_1 may include a communication channel identifier 1131_1, a response type identifier 1132_1, and data information 1133_1.

For example, as illustrated in FIG. 9, "0" recorded in bit number 6 representing the response type identifier 1132_1 may indicate that the data delimiter is the first type.

Referring to FIG. 9, when the data delimiter is the first type, the data information 1133_1 may include DTC information. For example, if the second bit of the request data 1130_1 is "0" as illustrated in FIG. 9, the other bits (bit numbers 0 to 5) in byte number 4 are "0", and byte number 5, byte number 6, and byte number 7 may include one piece of DTC information.

When the communication channel identifier 1131 is the first communication channel, since the CAN communication channel is used, the request message 11 may be 8 bytes at most.

Therefore, if the communication channel identifier 1131 is the first communication channel and the response type identifier 1132 is the first type, the request message 11 may include one piece of DTC information corresponding to byte number 5, byte number 6, and byte number 7. The one piece of DTC information may indicate DTC code information for requesting a read of an FDC. For example, the one piece of DTC information may be "0A0001". If the response type identifier 1132 is the first type, the request message 11 may further include delimiting information. Here, the delimiting information may be dummy data for delimiting the plurality of pieces of DTC information.

For example, byte numbers 5 to 7 may include first DTC information, and byte number 8 may include delimiting information. In this way, the request message 11 of the first type that uses a first communication channel and does not use a bitmap may request a read of an FDC corresponding to one DTC at most.

In addition, if the communication channel identifier 1131 is the first communication channel and the response type identifier 1132 is the second type, the request message 11 may request a read of an FDC corresponding to each of a plurality of DTCs using a plurality of bits in byte numbers 4 to 8. In this case, since the data information area of the request message 11 is 5 bytes, the request message 11 of the second type that uses a first communication channel and uses a bitmap, may request a read of FDCs corresponding to 8*5-2=38 DTCs at most.

If the communication channel identifier 1131 is the second communication channel, since a CAN FD communication channel is used, the request message 11 may be 64 bytes at most.

Accordingly, if the communication channel identifier 1131 is the second communication channel and the response type identifier 1132 is the first type, the request message 11 may include a plurality of pieces of DTC information and delimiting information in an area from byte numbers 5 to 64.

For example, byte numbers 5 to 7 may include first DTC information, byte number 8 may include delimiting information, bytes 9 to 11 may include second DTC information, byte number 12 may include delimiting information, byte numbers 13 to 15 may include third DTC information, byte number 16 may include delimiting information, byte numbers 17 to 19 may include fourth DTC information, and byte number 20 may include delimiting information.

In this way, the request message 11 of the first type that uses a second communication channel and does not use a bitmap may request a read of FDCs corresponding to 15 DTCs at most.

In addition, if the communication channel identifier 1131 is the second communication channel and the response type identifier 1132 is the second type, the request message 11 may request a read of an FDC corresponding to each of a plurality of DTCs using a plurality of bits in byte numbers 4 to 64. In this case, since the data information area of the request message 11 is 61 bytes, the request message 11 of the second type that uses a second communication channel and uses a bitmap, may request a read of FDCs corresponding to 8*61-2=486 DTCs at most.

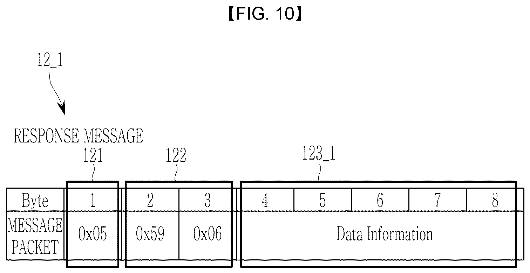

FIG. 10 is a diagram illustrating a structure of a response message that does not use a bitmap according to an exemplary embodiment.

As illustrated in FIG. 10, a response message 12_1 may include a packet size information area 121, a packet identification information area 122, and a data information area 123_1. The description of the packet size information area 121 and the packet identification information area 122 illustrated in FIG. 10 may be the same as the description of the packet size information area 121 and the packet identification information area 122 illustrated in FIG. 7. Hereinafter, the description of the packet size information area 121 and the packet identification information area 122 overlapping the above description may be omitted.

The number illustrated in FIG. 10 may be hexadecimal and expressed as 1 byte, and the size of data illustrated as one cell in the request message 11_1 may be 1 byte.

A response message 12_1 illustrated in FIG. 10 may be a response to the request message 11_1 of which the response type identifier 1132 is the first type as illustrated in FIG. 8. Even when the response type identifier 1132 is the first type, the communication channel identifier 1131 may be a first communication channel or a second communication channel.

First, the case where the communication channel identifier 1131 of the request message 11_1 is the first communication channel will be described.

The data information area 123_1 may correspond to a plurality of bytes starting from byte number 4. Although it is illustrated in FIG. 10 that the data information area 123_1 is an area corresponding to five bytes, byte numbers 4 to 8, this is for convenience of explanation, and exemplary embodiments are not limited thereto.

The data information area 123_1 may include DTC information requested to be read in the request message 11_1 and a diagnosis result corresponding to the DTC requested to be read. Here, the diagnosis result corresponding to the DTC requested to be read may include an FDC value for the corresponding DTC information.

The MCU 200 may record DTC information included in byte numbers 5 to 7 of the request message 11_1 in byte numbers 4 to 6 of the data information area 123_1, and record an FDC corresponding to the DTC recorded in bytes 4 to 6 in byte 7 of the data information area 123_1.

For example, "0A0001" may be recorded in byte numbers 4 to 6 of the data information area 123_1, and "0x27", which is an FDC corresponding to "0A0001", may be recorded in byte number 7 of the data information area 123_1.

Next, the case where the communication channel identifier 1131 of the request message 11_1 is the second communication channel will be described.

If the communication channel identifier 1131 of the request message 11_1 is the second communication channel and the response type identifier 1132 is the first type, the response message 12_1 may include a plurality of pieces of DTC information, an FDC for each of the plurality of pieces of DTC information, and delimiting information in the area from byte 5 to byte 64. Here, the delimiting information may be dummy data for delimiting the plurality of pieces of DTC information or the FDCs corresponding to the plurality of pieces of DTC information. The BMS 310 may configure the data information area 123_1 by sequentially arranging the plurality of DTCs included in the request message 11_1 and the FDCs corresponding to the respective DTCs.

For example, if the diagnostic information data excluding the delimiter information in the data information area 113_1 of the request message 11_1 includes first DTC information and second DTC information, the BMS 310 may configure the data information area 123_1 of the response message 12_1 by sequentially arranging first DTC information, an FDC corresponding to the first DTC information, second DTC information, and an FDC corresponding to the second DTC information. Here, the delimiter information of the data information area 113_1 may include the communication channel identifier 1131, which is a second communication channel, and the response type identifier 1132, which is a second type.

For example, byte numbers 5 to 7 may include first DTC information, byte number 8 may include an FDC value corresponding to the first DTC information, and byte number 9 may include delimiting information. Byte numbers 10 to 12 may include second DTC information, byte number 13 may include an FDC value corresponding to the second DTC information, and byte number 14 may include delimiting information. Byte numbers 15 to 17 may include third DTC information, byte number 18 may include an FDC value corresponding to the third DTC information, and byte number 19 may include delimiting information. Byte numbers 20 to 22 may include fourth DTC information, byte number 23 may include an FDC value corresponding to the fourth DTC information, and byte number 24 may include delimiting information.

In this way, when the first type that does not use a bitmap is used, the length of the response message to the request message 11_1 requesting four pieces of DTC information may be 24 bytes.

Although the exemplary embodiments of the present disclosure have been described in detail above, the scope of the present disclosure is not limited thereto, and various modifications and improvements made by those having ordinary knowledge in the art to which the present disclosure pertains also fall within the scope of the present disclosure.

## Claims

1. A method for transmitting and receiving fault detection counter (FDC) information for a diagnostic trouble code (DTC) by a battery system, the method comprising:
receiving a request message; and
transmitting a response message corresponding to the request message,
wherein a data information area of the request message includes a data delimiter and diagnostic information data,
wherein the data delimiter is a first type for requesting a read of an FDC corresponding to each of at least one piece of DTC information included in the request message, or a second type for requesting a read of a plurality of FDCs according to a bitmap, and
wherein the bitmap is a list in which a plurality of pieces of DTC diagnostic information match a plurality of bits constituting the diagnostic information data.

2. The method of claim 1, wherein
if the data delimiter is the second type,
the diagnostic information data includes binary data in which a binary value corresponds to each of the plurality of bits, and
bits having a first value among the binary data match a plurality of first DTCs based on the bitmap.

3. The method of claim 2, wherein
a data information area of the response message includes a plurality of FDCs corresponding to the plurality of first DTCs.

4. The method of claim 2, wherein
if the plurality of first DTCs include a DTC matching a first bit and a DTC matching a second bit greater than the first bit based on the bitmap,
a data information area of the response message includes a data information area in which an FDC corresponding to the DTC matching the first bit and an FDC corresponding to the DTC matching the second bit are arranged sequentially.

5. The method of claim 1, wherein
if a type of the response message is the first type,
the diagnostic information data includes first DTC information and second DTC information.

6. The method of claim 5, wherein
a data information area of the response message is configured by sequentially arranging the first DTC information, an FDC corresponding to the first DTC information, the second DTC information, and an FDC corresponding to the second DTC information.

7. A battery system for transmitting and receiving fault detection counter (FDC) information for a diagnostic trouble code (DTC) to and from a vehicle, the battery system comprising:
a battery pack including a plurality of battery cells; and
a battery management system (BMS) configured to manage the battery pack,
wherein the BMS receives a request message from the vehicle, and transmits a response message corresponding to the request message to the vehicle,
a data information area of the request message includes a data delimiter and diagnostic information data,
the data delimiter is a first type for requesting a read of an FDC corresponding to each of at least one piece of DTC information included in the request message, or a second type for requesting a read of a plurality of FDCs according to a bitmap, and
the bitmap is a list in which a plurality of pieces of DTC diagnostic information match a plurality of bits constituting the diagnostic information data.

8. The battery system of claim 7, wherein
if the data delimiter is the second type,
the diagnostic information data includes binary data in which a binary value corresponds to each of the plurality of bits, and
a plurality of first bits matching a plurality of pieces of DTC diagnostic information to be requested to be read based on the bitmap, among the plurality of bits represented by the binary data, have a first value, and a remainder plurality of bits excluding the plurality of first bits have a second value.

9. The battery system of claim 8, wherein
a data information area of the response message includes a plurality of FDCs corresponding to the plurality of first DTCs.

10. The battery system of claim 8, wherein
if the plurality of first DTCs include a DTC matching a first bit and a DTC matching a second bit greater than the first bit based on the bitmap,
the BMS configures a data information area of the response message by sequentially arranging an FDC corresponding to the DTC matching the first bit and an FDC corresponding to the DTC matching the second bit.

11. The battery system of claim 7, wherein
if a type of the response message is the first type,
the diagnostic information data includes first DTC information and second DTC information.

12. The battery system of claim 11, wherein
the BMS configures a data information area of the response message by sequentially arranging the first DTC information, an FDC corresponding to the first DTC information, the second DTC information, and an FDC corresponding to the second DTC information.
